# FASCICULE DE BREVET EUROPEEN

(11) **EP 3 502 047 B1**
(45) Date de publication et mention de la délivrance du brevet: **01.04.2026**
(21) Numéro de dépôt: 18214896.5
(22) Date de dépôt: 20.12.2018
(51) Int. Cl.: H10D 64/01, H10D 64/23, H10D 30/43, H10D 30/01, H10D 62/10, H10D 62/13, H10P 32/14, B82Y 10/00

(54) **TRANSISTOR FET À NANOFIL À RESISTANCE DE CONTACT REDUITE**
NANODRAHT FELDEFFEKT-TRANSISTOR MIT REDUZIERTEM KONTAKTWIDERSTAND
NANOWIRE FIELD EFFECT TRANSISTOR WITH REDUCED CONTACT RESISTANCE

(30) Priorité: 22.12.2017 US 201715852648
(43) Date de publication de la demande: 26.06.2019
(73) Titulaire: Commissariat à l'Energie Atomique et aux Energies Alternatives, 75015 Paris (FR)
(72) Inventeur: COQUAND, Rémi, 73800 LES MARCHES (FR); REBOH, Shay, 38054 GRENOBLE Cedex 09 (FR)
(74) Mandataire: Santarelli

(56) Documents cités:
- WO-A1-2011/067069
- WO-A1-2017/052618
- US-A1- 2010 295 022
- US-A1- 2014 001 520
- US-A1- 2017 256 609
- US-A1- 2017 288 018
- US-B1- 9 601 379

## Description

### DOMAINE TECHNIQUE ET ART ANTÉRIEUR

L'invention concerne le domaine de la réalisation de transistors FET (« Field Effect Transistor », ou transistor à effet de champ) comprenant un canal formé d'une ou plusieurs portions de semi-conducteur disposées au-dessus d'un substrat. L'invention s'applique avantageusement pour des transistors de type GAAFET (« Gate All Around Field Effect Transistor »), ou transistors FET à grille enrobante, dans lesquels le canal est formé d'un ou plusieurs nanofils (« nanowire » en anglais) ou nano-feuilles (« nanosheets » en anglais). L'invention s'applique notamment à la réalisation de transistors FET destinés à des applications logiques à hautes performances et basse consommation de la microélectronique.

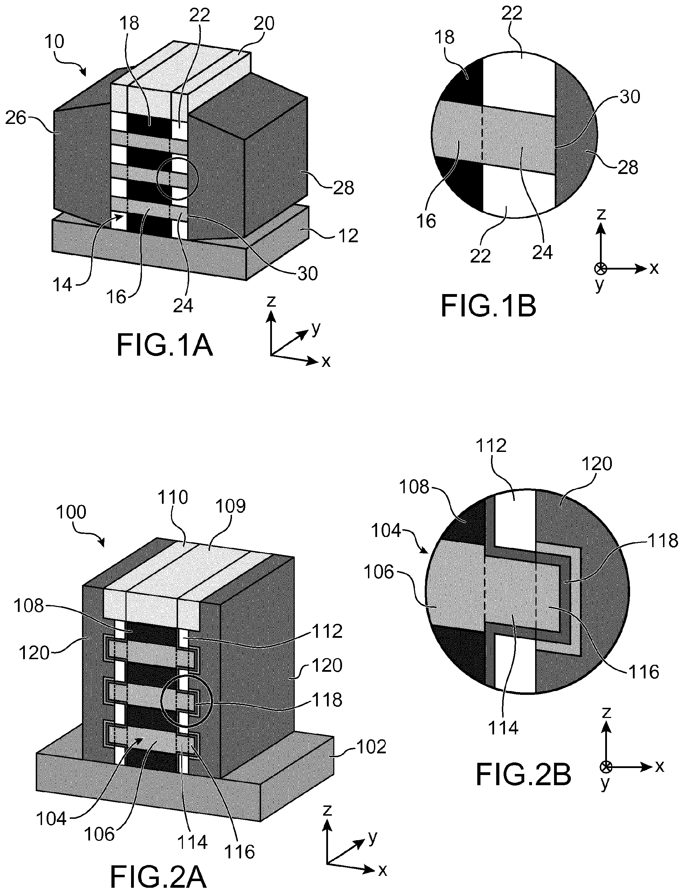

Un transistor GAAFET 10 est représenté sur la figure 1A. Ce transistor 10 est réalisé sur un substrat 12 de silicium. Le canal du transistor 10 est formé par trois nanofils 14 de silicium superposés les uns au-dessus des autres et suspendus au-dessus du substrat 12. Une première partie 16 de chaque nanofil 14 est recouverte par une grille 18 disposée entre des espaceurs externes 20. Ces premières parties 16 des nanofils 14 forment le canal du transistor 10. Le transistor 10 comporte également des espaceurs internes 22 disposés autour de deuxièmes parties 24 de chaque nanofil 14. Sur la figure 1A, les deuxièmes parties 24 sont délimitées symboliquement des premières parties 16 par des traits en pointillé. Ces deuxièmes parties 24 des nanofils 14 forment des régions d'extension interposées entre le canal, c'est-à-dire les premières parties 16 des nanofils 14, et des régions de source et de drain 26, 28 en contact avec des extrémités 30 des nanofils 14 et formées notamment par épitaxie de semi-conducteur sur lequel des contacts électriques (non visibles sur la figure 1A) sont réalisés. Une vue détaillée d'une partie du transistor 10 où est localisée une des régions d'extension du transistor 10 est représentée sur la figure 1B.

Dans le transistor 10 visible sur les figures 1A et 1B, la surface de contact entre les régions d'extension, formées par les deuxièmes parties 24 des nanofils 14, et les régions de source et de drain 26, 28 correspond uniquement à la surface des extrémités 30 des nanofils 14 (surface perpendiculaire à la direction de circulation du courant dans les nanofils 14, c'est-à-dire perpendiculaire à l'axe X représenté sur les figures 1A et 1B). Cette surface de contact est limitée étant donné les faibles dimensions des nanofils 14. Or, la valeur de la résistance électrique de contact, qui est idéalement la plus faible possible, formée entre les régions de source et de drain et le canal au niveau de cette surface de contact est inversement proportionnelle à la valeur de cette surface de contact. Avec l'architecture du transistor 10 décrit précédemment dans lequel les dimensions des nanofils 14 sont généralement réduites autant que possible pour des raisons d'encombrement, il est donc difficile de réduire la valeur de cette résistance électrique de contact du transistor 10. Le document WO2011067069A1 présente une structure de transistor FET avec un canal formé dans un nano-fil, une grille totalement enrobante, des espaceurs isolants, et des régions de source et de drain dopées formées par épitaxie. Les espaceurs isolants sont formés contre la grille et enrobent des régions dopées des nano-fils.

### EXPOSÉ DE L'INVENTION

Un but de la présente invention est de proposer un transistor FET dont l'architecture permet, pour une région de canal de dimensions données, de réduire la valeur de la résistance électrique de contact entre les régions d'extension et les régions de source et de drain du transistor FET.

Pour cela, la présente invention propose un transistor FET comportant au moins les caractéristiques techniques de la revendication 1.

Ainsi, dans ce transistor, il est proposé de réduire les dimensions des espaceurs internes afin qu'ils ne recouvrent pas les troisièmes parties de la portion de semi-conducteur qui s'étendent depuis les extrémités de la portion de semi-conducteur jusqu'aux deuxièmes parties de la portion de semi-conducteur formant les régions d'extension du transistor. Ces troisièmes parties et les extrémités sont chacune dopées afin de former, avec les portions électriquement conductrices, les régions de source et de drain du transistor. La surface de contact entre la portion de semi-conducteur (ou les portions de semi-conducteur lorsque le canal du transistor est formé de plusieurs portions de semi-conducteur distinctes), au niveau des troisièmes parties et des extrémités de la portion de semi-conducteur, et les portions électriquement conductrices des régions de source et de drain obtenue avec une telle architecture est donc plus important que celle obtenue dans la structure du transistor FET de l'art antérieur précédemment décrit car cette surface de contact correspond ici à la somme des surfaces dopées des extrémités et des troisièmes parties de la ou des portions de semi-conducteur. Ainsi, la surface de contact entre les régions de source et de drain et la ou les portions de semi-conducteur formant le canal du transistor est plus importante, ce qui se traduit par une réduction de la résistance électrique de contact entre les régions de source et drain et le canal du transistor.

Etant donné le dopage réalisé en surface des troisièmes parties de la portion de semi-conducteur, il n'est pas nécessaire de réaliser une épitaxie de portions de semi-conducteur pour obtenir les régions de source et drain du transistor. Les portions électriquement conductrices qui sont directement en contact avec les surfaces dopées des extrémités et des troisièmes parties de la ou des portions de semi-conducteur permettent donc de fortement réduire l'encombrement total du transistor FET. Ce transistor est donc compatible avec une intégration de plusieurs transistors FET réalisés sur un même substrat avec une forte densité.

Les surfaces des extrémités de la portion de semi-conducteur correspondent aux surfaces de cette portion de semi-conducteur qui sont sensiblement perpendiculaires à la direction de circulation du courant dans cette portion de semi-conducteur lors du fonctionnement du transistor.

Le transistor peut être tel que :
- la portion de semi-conducteur est suspendue au-dessus d'un substrat ;
- une partie de la grille est disposée entre la première partie de la portion de semi-conducteur et le substrat ;
- une partie de chacun des espaceurs diélectriques internes est disposée entre l'une des deuxièmes parties de la portion de semi-conducteur et le substrat ;
- une partie de chacune des portions électriquement conductrices est disposée entre l'une des troisièmes parties de la portion de semi-conducteur et le substrat.

Une telle configuration correspond par exemple à celle d'un transistor GAAFET. La portion de semi-conducteur peut correspondre à un nanofil ou une nano-feuille de semi-conducteur, ou plus généralement une nanostructure de semi-conducteur dont la première partie formant le canal est entourée par la grille du transistor, en passant notamment entre le substrat et le canal.

De manière alternative, la portion de semi-conducteur peut être disposée sur le substrat. Cette configuration correspond par exemple à celle d'un transistor FinFET, dans lequel une partie de la grille n'est pas disposée entre le substrat et le canal.

Le transistor peut comporter plusieurs portions de semi-conducteur suspendues au-dessus du substrat et telles que des premières parties des portions de semi-conducteur forment ensemble le canal du transistor, et :
- la grille peut entourer chacune des premières parties des portions de semi-conducteur ;
- les espaceurs diélectriques internes peuvent être disposés autour des deuxièmes parties de chacune des portions de semi-conducteur;
- les portions électriquement conductrices peuvent être en contact avec les surfaces dopées des extrémités de chacune des portions de semi-conducteur et avec les surfaces dopées des troisièmes parties de chacune des portions de semi-conducteur.

Les deuxièmes parties de la portion de semi-conducteur peuvent comporter des surfaces dopées.

De manière générale, l'expression « surface dopée » peut désigner un dopage réalisé depuis une surface extérieure d'une portion de matériau et dans une profondeur de cette portion de matériau qui est inférieure à l'épaisseur totale de la portion de matériau. Dans le cas du transistor décrit dans ce document, le dopage réalisé au niveau des surfaces dopées des extrémités, des troisièmes parties et éventuellement des deuxièmes parties de la portion de semi-conducteur peut s'étendre depuis les surfaces extérieures jusqu'à une profondeur par exemple comprise entre environ 1 nm et 5 nm. Ce dopage est mis en œuvre tels que les dopants ne se retrouvent pas dans le canal.

Les espaceurs diélectriques internes peuvent comporter un matériau de permittivité diélectrique inférieure ou égale à environ 3,9. Un tel matériau diélectrique dit « Low-k » est avantageux car il autorise la réalisation d'espaceurs diélectriques internes très fins, c'est-à-dire ayant une épaisseur (dimension des espaceurs diélectriques internes sensiblement parallèle à la direction de circulation du courant dans le canal du transistor) par exemple comprise entre environ 2 nm et 8 nm, et par exemple égale à environ 6 nm. De tels espaceurs diélectriques fins contribuent à la possibilité de réaliser le transistor avec de faibles dimensions.

Le transistor FET comporte en outre des espaceurs diélectriques externes entre lesquels est disposée la grille et entourant partiellement un ensemble formé au moins par les deuxièmes et troisièmes parties de la portion de semi-conducteur, les espaceurs diélectriques internes et les parties des portions électriquement conductrices en contact avec les surfaces dopées des troisièmes parties de la portion de semi-conducteur.

Les portions électriquement conductrices peuvent comporter au moins un métal, et peuvent être formées par exemple par des empilements de plusieurs matériaux électriquement conducteurs.

Une couche de siliciure peut être interposée entre les surfaces dopées des extrémités et des troisièmes parties de la portion de semi-conducteur et les portions électriquement conductrices.

L'invention concerne également un procédé de réalisation d'au moins un transistor FET, comprenant au moins la mise en œuvre des étapes définies dans la revendication 8.

Le dopage des extrémités et des troisièmes parties de la portion de semi-conducteur peut être réalisé par la mise en œuvre des étapes suivantes :
- dépôt, au moins contre des surfaces formées par les extrémités et les troisièmes parties de la portion de semi-conducteur, d'un matériau diélectrique comprenant des dopants ;
- recuit thermique diffusant les dopants depuis le matériau diélectrique comprenant les dopants jusque dans le semi-conducteur des extrémités et des troisièmes parties de la portion de semi-conducteur ;
- retrait du matériau diélectrique comprenant les dopants.

L'étape de dopage peut être mise en œuvre telle que les deuxièmes parties de la portion de semi-conducteur soient également dopées.

Le procédé peut comporter en outre :
- entre les étapes de retrait des portions du matériau diélectrique et de retrait de la grille factice, un dépôt d'un matériau diélectrique d'encapsulation disposé contre les extrémités de la portion de semi-conducteur, les troisièmes parties de la portion de semi-conducteur et les espaceurs diélectriques internes ;
- entre les étapes de retrait de la grille factice et de réalisation des portions électriquement conductrices, une étape de gravure d'emplacements des portions électriquement conductrices dans le matériau diélectrique d'encapsulation, les portions électriquement conductrices étant réalisées ensuite dans les emplacements gravés.

Le procédé peut comporter en outre, entre les étapes de retrait des portions du matériau diélectrique et de dépôt du matériau diélectrique d'encapsulation et/ou entre les étapes de gravure des emplacements des portions électriquement conductrices dans le matériau diélectrique d'encapsulation et de réalisation des portions électriquement conductrices, la mise en œuvre d'une étape de siliciuration des surfaces dopées des extrémités et des troisièmes parties de la portion de semi-conducteur.

Le procédé comporte en outre, avant la mise en œuvre du dopage des troisièmes parties et des extrémités de la portion de semi-conducteur, la réalisation d'espaceurs diélectriques externes entre lesquels la grille factice est disposée, les espaceurs diélectriques externes étant réalisés tels que par la suite, ils recouvrent partiellement un ensemble formé au moins par les deuxièmes et troisièmes parties de la portion de semi-conducteur, les espaceurs diélectriques internes et les parties des portions électriquement conductrices en contact avec les surfaces dopées des troisièmes parties de la portion de semi-conducteur.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A et 1B représentent un transistor GAAFET selon l'art antérieur;
- les figures 2A et 2B représentent un transistor FET, objet de la présente invention, selon un mode de réalisation particulier ;
- les figures 3 à 12 représentent les étapes d'un procédé de réalisation d'un transistor FET, objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

Un transistor FET 100 selon un mode de réalisation particulier est décrit ci-dessous en lien avec les figures 2A et 2B. Dans ce mode de réalisation particulier, le transistor 100 correspond à un transistor GAAFET.

Le transistor 100 est réalisé sur un substrat 102. Dans ce mode de réalisation particulier, le substrat 102 correspond à un substrat dit « bulk », ou massif, comprenant un semi-conducteur, du silicium.

En variante, le substrat sur lequel le transistor 100 est réalisé peut correspondre à un substrat de type semi-conducteur sur isolant, par exemple SOI (« Silicon On Insulator », ou silicium sur isolant) ou SiGeOl (« SiGe On Insulator »). Dans ce cas, la référence 102 visible sur les figures 2A et 2B désigne la couche diélectrique enterrée, ou BOX (« Buried Oxide »), de ce substrat.

Le transistor 100 comporte une ou plusieurs portions de semi-conducteur 104, par exemple en silicium. Dans le mode de réalisation particulier décrit ici, ces portions 104 correspondent à des nanofils de semi-conducteur suspendus au-dessus du substrat 102 et disposés les uns au-dessus des autres. Sur l'exemple représenté sur la figure 2A, le transistor 100 comporte trois portions 104. Plus généralement, le nombre de portions 104 du transistor 100 peut être compris entre 1 et 10.

En variante, la ou les portions 104 peuvent correspondre à des nanostructures de forme différentes des nanofils, par exemple des nano-feuilles (dont la largeur, qui correspond à la dimension selon l'axe Y représenté sur les figures 2A et 2B, est supérieure à la hauteur, qui correspond à la dimension selon l'axe Z représenté sur les figures 2A et 2B).

La longueur de chacune des portions 104 (dimension sensiblement parallèle à la direction de circulation du courant dans ces portions 104, et ici parallèle à l'axe X représenté sur les figures 2A et 2B) est par exemple comprise entre environ 10 nm et 150 nm. De plus, la hauteur de chacune des portions 104 (dimension sensiblement parallèle à l'axe Z représenté sur les figures 2A et 2B) est par exemple comprise entre environ 3 nm et 12 nm.

Le canal du transistor 100 est formé par des premières parties 106 des portions 104. Ces premières parties 106 des portions 104 sont recouvertes et entourées par une grille 108 formée d'au moins un diélectrique de grille recouvert d'au moins un matériau électriquement conducteur formant le matériau conducteur de grille.

Le transistor 100 comporte également des espaceurs diélectriques externes 110 entre lesquels la grille 108 et un contact électrique 109 de grille, contact électriquement le matériau conducteur de grille, sont disposés.

Le transistor 100 comporte également des espaceurs diélectriques internes 112 disposés autour de deuxièmes parties 114 des portions 104. Dans chacune des portions 104, la première partie 106 est disposée entre deux deuxièmes parties 114 de la portion 104. Les deuxièmes parties 114 des portions 104 forment des régions d'extension du transistor 100, c'est-à-dire des régions d'interface entre le canal et les régions de source et de drain du transistor 100. Sur les figures 2A et 2B, les deuxièmes parties 114 des portions 104 dont séparées symboliquement des premières parties 106 des portions 104 par des traits en pointillé.

Contrairement au transistor 10 de l'art antérieur dans lequel les espaceurs internes 22 s'étendent jusqu'aux extrémités 30 des nanofils 14, les espaceurs diélectriques internes 112 ne recouvrent pas des troisièmes parties 116 des portions 104 qui sont telles que chacune des deuxièmes parties 114 de chacune des portions 104 est disposée entre la première partie 106 de cette portion 104 et l'une des troisièmes parties 116 de cette portion 104. Sur les figures 2A et 2B, les deuxièmes parties 114 des portions 104 sont séparées symboliquement des troisièmes parties 116 des portions 104 par des traits en pointillé.

Dans le mode de réalisation particulier décrit ici, les espaceurs diélectriques internes 112 comportent un matériau diélectrique de permittivité diélectrique inférieure ou égale à environ 3,9, et correspond par exemple à du SiN (permittivité diélectrique égale à environ 7). Un tel matériau diélectrique correspond à un matériau diélectrique dit « Low-k ».

Dans le mode de réalisation particulier décrit ici, les espaceurs diélectriques internes 112 ont en outre une épaisseur (dimension sensiblement parallèle à la direction de circulation du courant dans le canal du transistor, c'est-à-dire ici sensiblement parallèle à l'axe X représenté sur les figures 2A et 2B) par exemple comprise entre environ 2 nm et 10 nm, et par exemple égale à environ 6 nm.

Les surfaces des portions 104 qui sont perpendiculaires à la direction selon laquelle s'étendent les portions 104, et perpendiculaires à l'axe X représenté sur la figure 2A et 2B, et qui se trouvent au bout des troisièmes parties 116 des portions 104, forment des extrémités 118 des portions 104.

Les extrémités 118, les troisièmes parties 116 et les deuxièmes parties 114 des portions 104 sont dopées au moins en surface de manière conforme. Autrement dit, le semi-conducteur dopé des extrémités 118, des troisièmes parties 116 et des deuxièmes parties 114 des portions 104 est localisé dans une partie de l'épaisseur des portions 104 qui s'étend depuis la surface extérieure des portions 104 et jusqu'à une profondeur d'une partie seulement de l'épaisseur totale des portions 104. Cette profondeur est par exemple comprise entre environ 1 nm et 5 nm.

Le dopage du semi-conducteur des extrémités 118, des troisièmes parties 116 et des deuxièmes parties 114 des portions 104 peut être de type n ou p, en fonction du type du transistor 100.

Le transistor 100 comporte également des portions électriquement conductrices 120 en contact électriquement avec les surfaces dopées des extrémités 118 et des troisièmes parties 116 des portions 104. Ces portions électriquement conductrices 120 font partie des régions de source et drain du transistor 100. Les portions électriquement conductrices 120 sont par exemple chacune formée d'un ou plusieurs matériaux électriquement conducteurs. A titre d'exemple, chacune des portions électriquement conductrices 120 peut par exemple être formée d'un empilement de Ti, de TiN et de W.

Grâce à la surface de contact importante entre les portions électriquement conductrices 120 et les surfaces de semi-conducteur dopé des extrémités 118 et des troisièmes parties 116 des portions 104, la résistance de contact entre ces éléments du transistor 100 est fortement réduite.

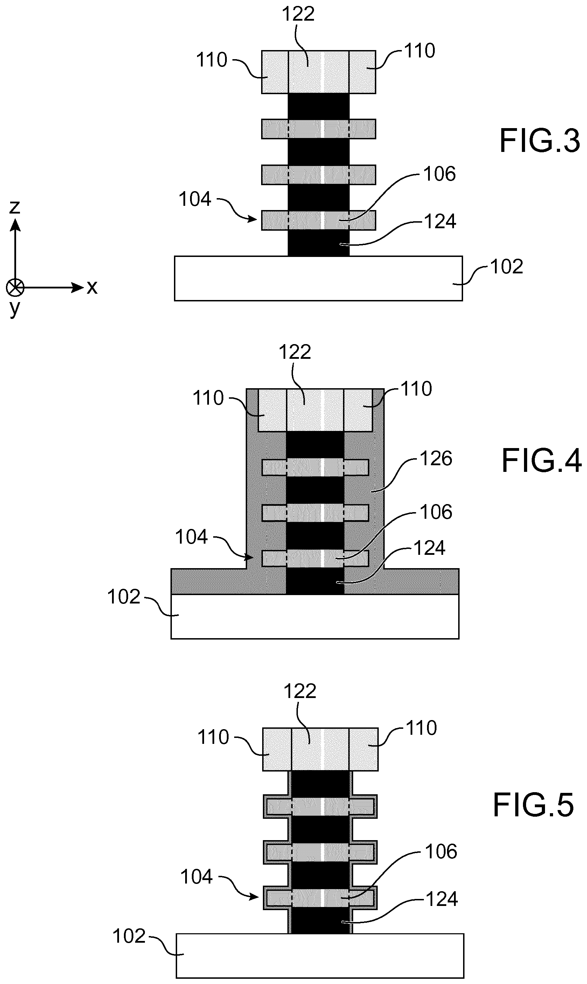

Un exemple de procédé de réalisation du transistor 100 est décrit ci-dessous en lien avec les figures 3 à 12.

Un empilement de première et deuxièmes couches, disposées de manière alternée les unes au-dessus des autres, est formé sur le substrat 102. Les deuxièmes couches sont destinées à former les portions 104 et comportent ici du silicium. Les premières couches comportent un matériau apte à être gravé sélectivement par rapport à celui des deuxièmes couches. Dans l'exemple de procédé décrit ici, les premières couches comportent du SiGe.

Lorsque le substrat 102 correspond à un substrat de type semi-conducteur sur isolant, la référence 102 peut désigner la couche diélectrique enterrée et la première couche disposée contre cette couche diélectrique enterrée peut correspondre à la couche superficielle du substrat.

Une grille factice 122 (« dummy gate » en anglais »), ou grille temporaire, et des espaceurs diélectriques externes 110 sont réalisés sur cet empilement de premières et deuxièmes couches. Cet empilement est ensuite gravé afin de ne conserver que les parties de ces couches qui sont recouvertes par la grille factice 122 et par les espaceurs diélectriques externes 110. Les parties restantes des deuxièmes couches correspondent aux portions 104. Des parties des premières couches, de dimensions similaires à celles des portions 104, sont disposées entre les portions 104 et entre la première portion 104 (celle la plus proche du substrat 102) et le substrat 102. Les parties des portions 104 recouvertes par la grille factice 122 correspondent aux premières parties 106 destinées à former le canal du transistor 100.

Comme représenté sur la figure 3, les parties restantes des premières couches sont ensuite partiellement gravées depuis leurs faces latérales (faces parallèles au plan (Z,Y) représenté sur la figure 3). Cette gravure est mise en œuvre telle que les portions des premières couches localisées sous les espaceurs diélectriques externes 110, ou à l'aplomb des espaceurs diélectriques externes 110, soient supprimées. A l'issue de cette gravure, seules des parties 124 des premières couches entourant les premières parties 106 des portions 104 sont conservées. Ainsi, le semi-conducteur des portions 104 destiné à former les deuxièmes parties 114 et les troisièmes parties 116 ainsi que les extrémités 118 des portions 104 n'est pas recouvert par le matériau des premières couches, ici du SiGe.

Un dopage du semi-conducteur des portions 104 non recouvert par les parties 124 est ensuite réalisé. Pour cela, un matériau diélectrique 126 comportant des dopants est déposé de manière conforme sur la structure précédemment réalisée (figure 4), et notamment contre les extrémités 118 des portions 104 ainsi que dans les espaces vides laissés par la précédente gravure partielle des parties restantes des premières couches. Ce matériau diélectrique 126 est par exemple un oxyde tel que du PSG (« Phosphosilicate Glass », ou verre au phosphosilicate). La nature des dopants présents dans ce matériau diélectrique dépend du type (n ou p) de dopage destiné à être réalisé pour former les régions de source et de drain du transistor 100. La concentration en dopants dans le matériau diélectrique 126 peut être comprise entre environ 10¹⁹ at/cm³ et 10²² at/cm³.

A l'issue de ce dépôt, le matériau diélectrique 126 recouvre notamment les extrémités 118 ainsi que les surfaces des deuxièmes parties 114 et des troisièmes parties 116 des portions 104.

Un recuit est ensuite mis en œuvre afin de provoquer une diffusion thermique des dopants depuis le matériau diélectrique 126 à travers les surfaces de semi-conducteur des portions 104 qui sont recouvertes par le matériau diélectrique 126. La température à laquelle ce recuit est mis en œuvre est par exemple comprise entre environ 800°C et 1100°C, pendant une durée par exemple inférieure à environ 10 secondes (et par exemple égale à environ 1 seconde), et est ajustée afin de ne pas diffuser des atomes de semi-conducteur depuis les parties 124 dans le semi-conducteur des portions 104, c'est-à-dire ici ne pas diffuser des atomes de germanium issus des parties 124 dans le silicium des portions 104.

Le dopage ainsi réalisé est uniforme sur toute la surface du semi-conducteur qui est recouverte par le matériau diélectrique 126. Ce dopage par diffusion thermique permet en outre d'éviter de doper le semi-conducteur des premières parties 106 des portions 104 destinées à former le canal du transistor 100. Cette technique de dopage a également pour avantage de ne pas endommager les surfaces dopées. Les parties des portions 104 dans lesquelles le dopage est réalisé correspondent notamment à toutes les parties autres que les premières parties 106, et qui sont destinées à faire partie des régions d'extension du transistor 100 ainsi que des régions de source et de drain du transistor 100.

Un exemple détaillé de mise en œuvre d'un tel dopage sont décrits dans le document « Novel Junction Design for NMOS Si Bulk-FinFETs with Extension Doping by PEALD Phosphorus Doped Silicate Glass » de Y. Sasaki et al., IEDM15 596-599.

A l'issue de ce recuit, le matériau diélectrique 126 est retiré (figure 5). Ce retrait est par exemple mis en œuvre en utilisant une solution de HF.

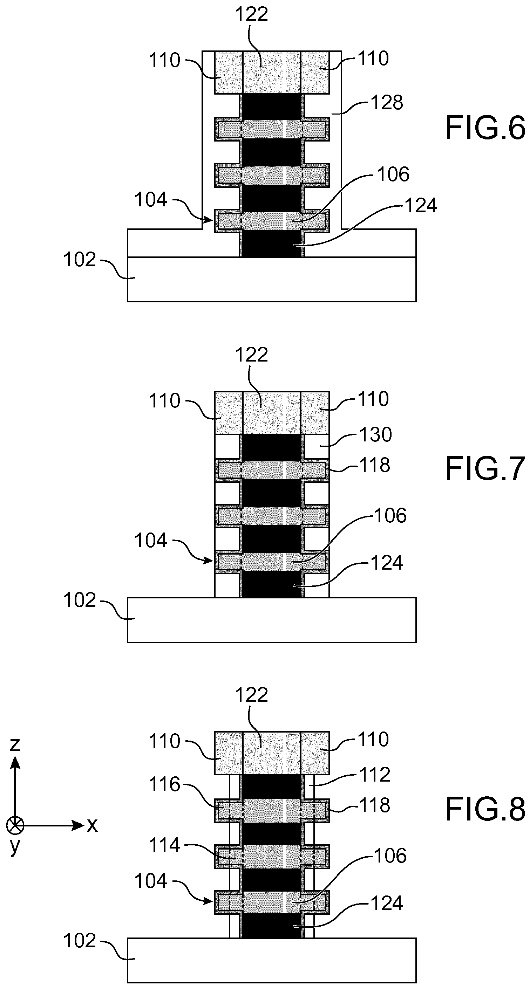

Un matériau diélectrique 128, par exemple du SiN, est ensuite déposé de manière sensiblement conforme autour de la structure précédemment formée (figure 6). Ce matériau diélectrique 128 est notamment déposé entre les portions 104, contre les faces latérales des portions 124 de SiGe, c'est-à-dire dans les espaces vides laissés par la précédente gravure partielle des parties restantes des premières couches.

Une gravure isotrope est ensuite mise en œuvre afin de supprimer les portions du matériau diélectrique 128 qui ne sont pas disposées dans les espaces vides laissés par la précédente gravure partielle des parties restantes des premières couches. Seules des portions restantes 130 du matériau diélectrique sont conservées (figure 7). Cette gravure isotrope correspond par exemple à une gravure humide mise en œuvre avec de l'acide phosphorique. A l'issue de cette gravure, les extrémités 118 des portions 104 ne sont plus recouvertes par le matériau diélectrique 128.

Comme représenté sur la figure 8, une gravure partielle des portions restantes 130 est mise en œuvre afin que les troisièmes parties 116 des portions 104 ne soient plus recouvertes par le matériau diélectrique des portions restantes 130. Cette gravure partielle correspond par exemple à une gravure isotrope, par exemple similaire à celle précédemment mise en œuvre pour la gravure du matériau diélectrique 128. Le matériau diélectrique conservé forme les espaceurs diélectriques internes 112 disposés autour des deuxièmes parties 114 des portions 104 qui forment les régions d'extension du transistor 100.

Compte tenu de la faible épaisseur (dimension parallèle à l'axe X représenté sur la figure 8) des espaceurs internes 112 (par exemple comprise entre environ 2 nm et 10 nm), le matériau diélectrique 128 utilisé pour former les espaceurs diélectriques internes 112 est avantageusement de type Low-k, ou à faible permittivité diélectrique, c'est-à-dire dont la permittivité diélectrique est inférieure ou égale à environ 3,9, afin de conserver une épaisseur diélectrique équivalente suffisante. Ce matériau diélectrique est par exemple du SiBCN ou du SiOCH.

Une étape de siliciuration peut ensuite être mise en œuvre afin de former, en surface des troisièmes parties 116 et des extrémités 118 des portions 104, une couche de siliciure 131.

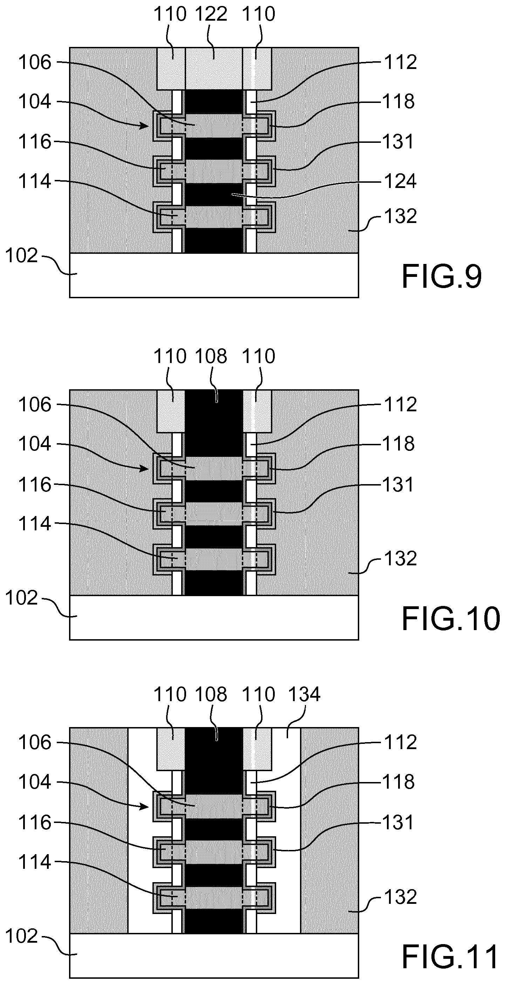

Un matériau diélectrique d'encapsulation 132, par exemple un oxyde tel que du SiO₂, est ensuite déposé, notamment autour de la structure formée à ce stade du procédé (figure 9). Ce matériau diélectrique d'encapsulation 132 est apte à être gravé sélectivement vis-à-vis des autres matériaux présents dans la structure. Une étape de planarisation mécano-chimique (CMP) peut être mise en œuvre, avec arrêt sur la grille factice 122 et sur les espaceurs externes 110, pour supprimer le matériau diélectrique d'encapsulation présent sur ces éléments.

Comme représenté sur la figure 10, la grille factice 122 et les parties 124 sont supprimées, et la grille définitive 108 est réalisée dans l'emplacement précédemment occupé par la grille factice 122 et les parties 124, en déposant le ou les diélectriques de grille et le ou les matériaux conducteurs de grille.

Des ouvertures 134 sont ensuite réalisées à travers le matériau diélectrique d'encapsulation 132, afin de rendre accessibles les extrémités 118 et les troisièmes parties 116 des portions 104 (figure 11). Ces ouvertures 134 forment des emplacements pour les futures portions électriquement conductrices des régions de source et de drain du transistor 100.

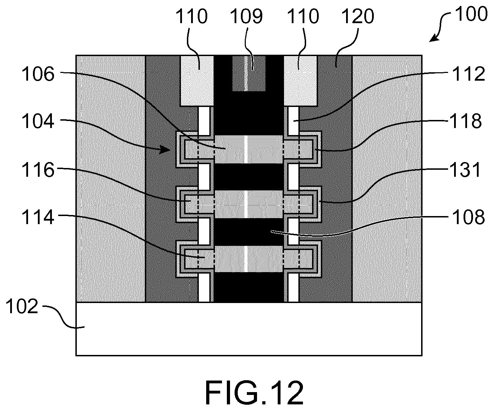

Un dépôt conforme de matériau électriquement conducteur est ensuite mis en œuvre afin de réaliser les portions électriquement conductrices 120 en contact électriquement avec la couche de siliciure 131 qui recouvre les extrémités 118 et les troisièmes parties 116 des portions 104 (figure 12).

Grâce à la gravure partielle des portions 130 mise en œuvre pour former les espaceurs internes 112 qui ne recouvrent pas les troisièmes parties 116 des portions 104, la surface de contact entre les portions 104 et les portions électriquement conductrices 120 (par l'intermédiaire de la couche de siliciure 131) est plus importante que lorsque seules les extrémités des portions 104 sont en contact avec les source et drain du transistor.

En variante du procédé décrit ci-dessus, il est possible que l'étape de siliciuration des troisièmes parties 116 et des extrémités 118 des portions 104 ne soit pas mise en œuvre entre l'étape formant les espaceurs internes 112 et l'étape de dépôt du matériau diélectrique d'encapsulation 132, mais entre l'étape de réalisation de la grille 108 et l'étape de réalisation des portions électriquement conductrices 120.

Dans le mode de réalisation particulier précédemment décrit, le dopage des portions 104 est réalisé via le dépôt d'un matériau diélectrique riche en dopants, puis un recuit diffusant les dopants dans les parties des portions 104 recouvertes par ce matériau diélectrique. En variante, le dopage des extrémités 118, des deuxièmes parties 114 et des troisièmes parties 116 des portions 104 peut être réalisé en mettant en œuvre d'autres techniques de dopage, comme par exemple un dopage par plasma.

Dans le mode de réalisation particulier décrit ci-dessous, le transistor 100 est un transistor GAAFET. En variante, le transistor 100 peut correspondre à un autre type de transistor, par exemple FinFET. Dans ce cas, le transistor comporte une ou plusieurs portions de semi-conducteur réalisées sous la forme de doigts disposés sur le substrat 102.

## Revendications

1. Transistor FET (100) comportant au moins :
- une portion de semi-conducteur (104) dont une première partie (106) forme un canal du transistor FET (100) ;
- une grille (108) entourant au moins partiellement la première partie (106) de la portion de semi-conducteur (104) ;
- des espaceurs diélectriques internes (112) disposés autour de deuxièmes parties (114) dopées de la portion de semi-conducteur (104) entre lesquelles est disposée la première partie (106) de la portion de semi-conducteur (104) et formant des régions d'extension du transistor FET (100) ;
- des portions électriquement conductrices (120, 131) en contact avec des surfaces dopées d'extrémités (118) de la portion de semi-conducteur (104) et avec des surfaces dopées de troisièmes parties (116) de la portion de semi-conducteur (104) faisant partie de régions de source et de drain du transistor FET (100), entourant au moins partiellement les troisièmes parties (116) de la portion de semi-conducteur (104), chacune des deuxièmes parties (114) de la portion de semi-conducteur (104) étant disposée entre la première partie (106) de la portion de semi-conducteur (104) et l'une des troisièmes parties (116) de la portion de semi-conducteur (104) ;
comportant en outre des espaceurs diélectriques externes (110) entre lesquels est disposée la grille (108) et recouvrant partiellement un ensemble formé par les deuxièmes et troisièmes parties (114, 116) de la portion de semi-conducteur (104), les espaceurs diélectriques internes (112) et les parties des portions électriquement conductrices (120, 131) en contact avec les surfaces dopées des troisièmes parties (116) de la portion de semi-conducteur (104) ;
dans lequel les surfaces dopées d'extrémités (118) de la portion de semi-conducteur (104) correspondent aux surfaces de cette portion de semi-conducteur qui sont sensiblement perpendiculaires à la direction de circulation du courant dans le canal du transistor FET (100) ;
et dans lequel une partie de chacun des espaceurs diélectriques externes (110) est disposée contre un des espaceurs diélectriques internes (112) disposé entre ledit chacun des espaceurs diélectriques externes (110) et l'une des deuxièmes parties (114) dopées de la portion de semi-conducteur (104).

2. Transistor FET (100) selon la revendication 1, dans lequel :
- la portion de semi-conducteur (104) est suspendue au-dessus d'un substrat (102) ;
- une partie de la grille (108) est disposée entre la première partie (106) de la portion de semi-conducteur (104) et le substrat (102) ;
- une partie de chacun des espaceurs diélectriques internes (112) est disposée entre l'une des deuxièmes parties (114) de la portion de semi-conducteur (104) et le substrat (102) ;
- une partie de chacune des portions électriquement conductrices (120, 131) est disposée entre l'une des troisièmes parties (116) de la portion de semi-conducteur (104) et le substrat (102).

3. Transistor FET (100) selon la revendication 2, comprenant plusieurs portions de semi-conducteur (104) suspendues au-dessus du substrat (102) et telles que des premières parties (106) des portions de semi-conducteur (104) forment ensemble le canal du transistor (100), et dans lequel :
- la grille (108) entoure chacune des premières parties (106) des portions de semi-conducteur (104) ;
- les espaceurs diélectriques internes (112) sont disposés autour des deuxièmes parties (114) de chacune des portions de semi-conducteur (104) ;
- les portions électriquement conductrices (120, 131) sont en contact avec les surfaces dopées des extrémités (118) de chacune des portions de semi-conducteur (104) et avec les surfaces dopées des troisièmes parties (116) de chacune des portions de semi-conducteur (104).

4. Transistor FET (100) selon l'une des revendications précédentes, dans lequel les deuxièmes parties (114) de la portion de semi-conducteur (104) comportent des surfaces dopées.

5. Transistor FET (100) selon l'une des revendications précédentes, dans lequel les espaceurs diélectriques internes (112) comportent un matériau de permittivité diélectrique inférieure ou égale à environ 3,9.

6. Transistor FET (100) selon l'une des revendications précédentes, dans lequel les portions électriquement conductrices (120, 131) comportent au moins un métal.

7. Transistor FET (100) selon l'une des revendications précédentes, dans lequel les portions électriquement conductrices (120, 131) comportent une couche de siliciure (131) interposée entre les surfaces dopées des extrémités (118) et des troisièmes parties (116) de la portion de semi-conducteur (104) et le reste (120) des portions électriquement conductrices (120).

8. Procédé de réalisation d'au moins un transistor FET (100), comprenant au moins la mise en œuvre des étapes suivantes :
- réalisation d'au moins une portion de semi-conducteur (104) dont une première partie (106) est destinée à former un canal du transistor FET (100) et comprenant en outre des deuxièmes parties (114) entre lesquelles est disposée la première partie (106) de la portion de semi-conducteur (104) et destinées à former des régions d'extension du transistor FET (100), ainsi que des troisièmes parties (116) destinées à faire partie de régions de source et de drain du transistor FET (100) et telles que chacune des deuxièmes parties (114) de la portion de semi-conducteur (104) soit disposée entre la première partie (106) de la portion de semi-conducteur (104) et l'une des troisièmes parties (116) de la portion de semi-conducteur (104) ;
- réalisation d'une grille factice (122) entourant au moins partiellement la première partie (106) de la portion de semi-conducteur (104) ;
- dopage d'au moins les troisièmes parties (116) de la portion de semi-conducteur (104) et d'extrémités (118) de la portion de semi-conducteur (104) ;
- dépôt d'au moins un matériau diélectrique (128) autour des deuxièmes et troisièmes parties (114, 116) de la portion de semi-conducteur (104) ;
- retrait de portions du matériau diélectrique (128) disposées autour des troisièmes parties (116) de la portion de semi-conducteur (104), des portions restantes du matériau diélectriques (128) disposées autour des deuxièmes parties (114) de la portion de semi-conducteur (104) formant des espaceurs diélectriques internes (112) ;
- retrait de la grille factice (122) et réalisation, dans un emplacement formé par le retrait de la grille factice (122), d'une grille (108) entourant au moins partiellement la première partie (106) de la portion de semi-conducteur (104) ;
- réalisation de portions électriquement conductrices (120, 131) en contact avec des surfaces dopées d'extrémités (118) de la portion de semi-conducteur (104) et avec des surfaces dopées des troisièmes parties (116) de la portion de semi-conducteur (104), et entourant au moins partiellement les troisièmes parties (116) de la portion de semi-conducteur (104) ;
comportant en outre, avant la mise en œuvre du dopage des troisièmes parties (116) et des extrémités (118) de la portion de semi-conducteur (104), la réalisation d'espaceurs diélectriques externes (110) entre lesquels la grille factice (122) est disposée, les espaceurs diélectriques externes (110) étant réalisés tels que par la suite, ils recouvrent partiellement les deuxièmes et troisièmes parties (114, 116) de la portion de semi-conducteur (104), les espaceurs diélectriques internes (112) et les parties des portions électriquement conductrices (120, 131) en contact avec les surfaces dopées des troisièmes parties (116) de la portion de semi-conducteur (104) ;
dans lequel les surfaces dopées d'extrémités (118) de la portion de semi-conducteur (104) correspondent aux surfaces de cette portion de semi-conducteur qui sont sensiblement perpendiculaires à la direction de circulation du courant dans le canal du transistor FET (100) ;
et dans lequel une partie de chacun des espaceurs diélectriques externes (110) est disposée contre un des espaceurs diélectriques internes (112) disposé entre ledit chacun des espaceurs diélectriques externes (110) et l'une des deuxièmes parties (114) dopées de la portion de semi-conducteur (104).

9. Procédé selon la revendication 8, dans lequel le dopage des extrémités (118) et des troisièmes parties (116) de la portion de semi-conducteur (104) est réalisé par la mise en œuvre des étapes suivantes :
- dépôt, au moins contre des surfaces formées par les extrémités (118) et les troisièmes parties (116) de la portion de semi-conducteur (104), d'un matériau diélectrique (126) comprenant des dopants ;
- recuit thermique diffusant les dopants depuis le matériau diélectrique (126) comprenant les dopants jusque dans le semi-conducteur des extrémités (118) et des troisièmes parties (116) de la portion de semi-conducteur (104) ;
- retrait du matériau diélectrique (126) comprenant les dopants.

10. Procédé selon l'une des revendications 8 et 9, dans lequel l'étape de dopage est mise en œuvre telle que les deuxièmes parties (114) de la portion de semi-conducteur (104) soient également dopées.

11. Procédé selon l'une des revendications 8 à 10, comportant en outre :
- entre les étapes de retrait des portions du matériau diélectrique (128) et de retrait de la grille factice (122), un dépôt d'un matériau diélectrique d'encapsulation (132) disposé contre les extrémités (118) de la portion de semi-conducteur (104), les troisièmes parties (116) de la portion de semi-conducteur (104) et les espaceurs diélectriques internes (112) ;
- entre les étapes de retrait de la grille factice (122) et de réalisation des portions électriquement conductrices (120, 131), une étape de gravure d'emplacements (134) des portions électriquement conductrices (120, 131) dans le matériau diélectrique d'encapsulation (132), les portions électriquement conductrices (120, 131) étant réalisées ensuite dans les emplacements (134) gravés.

12. Procédé selon la revendication 11, comportant en outre, lors de réalisation des portions électriquement conductrices (120, 131), la mise en œuvre d'une étape de siliciuration des surfaces dopées des extrémités (118) et des troisièmes parties (116) de la portion de semi-conducteur (104).

## Patentansprüche

1. FET-Transistor (100), der mindestens Folgendes aufweist:
- einen Halbleiterabschnitt (104), dessen erster Teil (106) einen Kanal des FET-Transistors (100) bildet;
- ein Gitter (108), das den ersten Teil (106) des Halbleiterabschnitts (104) mindestens teilweise umgibt;
- interne dielektrische Abstandshalter (112), die um zweite Teile (114) angeordnet sind, die mit dem Halbleiterabschnitt (104) dotiert sind, zwischen denen der erste Teil (106) des Halbleiterabschnitts (104) angeordnet ist und Erweiterungsbereiche des FET-Transistors (100) bilden;
- elektrisch leitende Abschnitte (120, 131), die in Kontakt mit dotierten Oberflächen der Enden (118) des Halbleiterabschnitts (104) und mit dotierten Oberflächen der dritten Teile (116) des Halbleiterabschnitts (104) stehen, die Teil von Quell- und Drain-Bereichen des FET-Transistors (100) sind, die die dritten Teile (116) des Halbleiterabschnitts (104) mindestens teilweise umgeben, wobei jeder der zweiten Teile (114) des Halbleiterabschnitts (104) zwischen dem ersten Teil (106) des Halbleiterabschnitts (104) und einem der dritten Teile (116) des Halbleiterabschnitts (104) angeordnet ist;
der ferner äußere dielektrische Abstandshalter (110) aufweist, zwischen denen das Gitter (108) angeordnet ist und teilweise eine Baugruppe abdeckt, die von den zweiten und dritten Teilen (114, 116) des Halbleiterabschnitts (104), den inneren dielektrischen Abstandshaltern (112) und den Teilen der elektrisch leitenden Abschnitte (120, 131) gebildet wird, die mit den dotierten Oberflächen der dritten Teile (116) des Halbleiterabschnitts (104) in Kontakt stehen;
wobei die dotierten Oberflächen der Enden (118) des Halbleiterabschnitts (104) den Oberflächen dieses Halbleiterabschnitts entsprechen, die im Wesentlichen senkrecht zu der Flussrichtung des Stroms in dem Kanal des FET-Transistors (100) sind;
und wobei ein Teil jedes der äußeren dielektrischen Abstandshalter (110) gegen einen der inneren dielektrischen Abstandshalter (112) angeordnet ist, der zwischen jedem der äußeren dielektrischen Abstandshalter (110) und einem der zweiten Teile (114) angeordnet ist, die mit dem Halbleiterabschnitt (104) dotiert sind.

2. FET-Transistor (100) nach Anspruch 1, wobei:
- der Halbleiterabschnitt (104) über einem Substrat (102) aufgehängt ist;
- ein Teil des Gitters (108) zwischen dem ersten Teil (106) des Halbleiterabschnitts (104) und dem Substrat (102) angeordnet ist;
- ein Teil jedes der inneren dielektrischen Abstandshalter (112) zwischen einem der zweiten Teile (114) des Halbleiterabschnitts (104) und dem Substrat (102) angeordnet ist;
- ein Teil jedes der elektrisch leitenden Abschnitte (120, 131) zwischen einem der dritten Teile (116) des Halbleiterabschnitts (104) und dem Substrat (102) angeordnet ist.

3. FET-Transistor (100) nach Anspruch 2, umfassend mehrere über dem Substrat (102) aufgehängte Halbleiterabschnitte (104) und so, dass erste Teile (106) der Halbleiterabschnitte (104) zusammen den Kanal des Transistors (100) bilden, und wobei:
- das Gitter (108) jeden der ersten Teile (106) der Halbleiterabschnitte (104) umgibt;
- die inneren dielektrischen Abstandshalter (112) um die zweiten Teile (114) jedes der Halbleiterabschnitte (104) angeordnet sind;
- die elektrisch leitenden Abschnitte (120, 131) mit den dotierten Oberflächen der Enden (118) jedes der Halbleiterabschnitte (104) und mit den dotierten Oberflächen der dritten Abschnitte (116) jedes der Halbleiterabschnitte (104) in Kontakt stehen.

4. FET-Transistor (100) nach einem der vorhergehenden Ansprüche, wobei die zweiten Teile (114) des Halbleiterabschnitts (104) dotierte Oberflächen aufweisen.

5. FET-Transistor (100) nach einem der vorhergehenden Ansprüche, wobei die inneren dielektrischen Abstandshalter (112) ein Material mit einer dielektrischen Permittivität von ungefähr 3,9 oder weniger aufweisen.

6. FET-Transistor (100) nach einem der vorhergehenden Ansprüche, wobei die elektrisch leitenden Abschnitte (120, 131) mindestens ein Metall aufweisen.

7. FET-Transistor (100) nach einem der vorhergehenden Ansprüche, wobei die elektrisch leitenden Abschnitte (120, 131) eine Siliziumschicht (131) aufweisen, die zwischen den dotierten Oberflächen der Enden (118) und der dritten Teile (116) des Halbleiterabschnitts (104) und dem Rest (120) der elektrisch leitenden Abschnitte (120) eingelegt ist.

8. Verfahren zum Herstellen eines Transistors (100), der mindestens das Durchführen folgender Schritte umfasst:
- Herstellen mindestens eines Halbleiterabschnitts (104), von dem ein erster Teil (106) dazu bestimmt ist, einen Kanal des FET-Transistors (100) zu bilden, und der ferner zweite Teile (114) umfasst, zwischen denen der erste Teil (106) des Halbleiterabschnitts (104) angeordnet ist und die dazu bestimmt sind, Erweiterungsbereiche des FET-Transistors (100) zu bilden, sowie dritte Teile (116), die dazu bestimmt sind, Teil von Quell- und Drainbereichen des FET-Transistors (100) zu sein, und so, dass jeder der zweiten Teile (114) des Halbleiterabschnitts (104) zwischen dem ersten Teil (106) des Halbleiterabschnitts (104) und einem der dritten Teile (116) des Halbleiterabschnitts (104) angeordnet ist;
- Herstellen eines Dummy-Gitters (122), das den ersten Teil (106) des Halbleiterabschnitts (104) mindestens teilweise umgibt;
- Dotieren mindestens der dritten Teile (116) des Halbleiterabschnitts (104) und der Enden (118) des Halbleiterabschnitts (104);
- Aufbringen von mindestens einem dielektrischen Material (128) um die zweiten und dritten Teile (114, 116) des Halbleiterabschnitts (104);
- Entfernen von Abschnitten des dielektrischen Materials (128), die um die dritten Abschnitte (116) des Halbleiterabschnitts (104) angeordnet sind, von den verbleibenden Abschnitten des dielektrischen Materials (128), die um die zweiten Abschnitte (114) des Halbleiterabschnitts (104) angeordnet sind, die innere dielektrische Abstandshalter (112) bilden;
- Entfernen des Dummy-Gitters (122) und Herstellen, an einer durch das Entfernen des Dummy-Gitters (122) gebildeten Stelle, eines Gitters (108), das den ersten Teil (106) des Halbleiterabschnitts (104) mindestens teilweise umgibt;
- Herstellen elektrisch leitender Abschnitte (120, 131), die in Kontakt mit dotierten Oberflächen der Enden (118) des Halbleiterabschnitts (104) und mit dotierten Oberflächen der dritten Teile (116) des Halbleiterabschnitts (104) stehen und die dritten Teile (116) des Halbleiterabschnitts (104) mindestens teilweise umgeben;
das ferner vor dem Durchführen des Dotierens der dritten Teile (116) und der Enden (118) des Halbleiterabschnitts (104) das Herstellen von äußeren dielektrischen Abstandshaltern (110) aufweist, zwischen denen das Dummy-Gitter (122) angeordnet ist, wobei die äußeren dielektrischen Abstandshalter (110) so hergestellt sind, dass sie später die zweiten und dritten Teile (114, 116) des Halbleiterabschnitts (104), die inneren dielektrischen Abstandshalter (112) und die Teile der elektrisch leitenden Abschnitte (120, 131), die in Kontakt mit den dotierten Oberflächen der dritten Teile (116) des Halbleiterabschnitts (104) stehen, teilweise bedecken;
wobei die dotierten Oberflächen der Enden (118) des Halbleiterabschnitts (104) den Oberflächen dieses Halbleiterabschnitts entsprechen, die im Wesentlichen senkrecht zu der Flussrichtung des Stroms in dem Kanal des FET-Transistors (100) sind;
und wobei ein Teil jedes der äußeren dielektrischen Abstandshalter (110) gegen einen der inneren dielektrischen Abstandshalter (112) angeordnet ist, der zwischen jedem der äußeren dielektrischen Abstandshalter (110) und einem der zweiten Teile (114) angeordnet ist, die mit dem Halbleiterabschnitt (104) dotiert sind.

9. Verfahren nach Anspruch 8, wobei das Dotieren der Enden (118) und der dritten Teile (116) des Halbleiterabschnitts (104) durch das Durchführen der folgenden Schritte erfolgt:
- Aufbringen eines dielektrisch Materials (126), das Dotierstoffe umfasst, mindestens auf die Oberflächen, die von den Enden (118) und den dritten Teilen (116) des Halbleiterabschnitts (104) gebildet werden;
- thermisches Glühen, um das die Dotierstoffe von dem dielektrischen Material (126), das die Dotierstoffe umfasst, bis in den Halbleiter der Enden (118) und der dritten Teile (116) des Halbleiterabschnitts (104) zu diffundieren;
- Entfernen des dielektrischen Materials (126), das die Dotierstoffe umfasst.

10. Verfahren nach einem der Ansprüche 8 und 9, wobei der Schritt des Dotierens so durchgeführt wird, dass die zweiten Teile (114) des Halbleiterabschnitts (104) ebenfalls dotiert sind.

11. Verfahren nach einem der Ansprüche 8 bis 10, das ferner Folgendes aufweist:
- zwischen den Schritten des Entfernens der Abschnitte des dielektrischen Materials (128) und des Entfernens des Dummy-Gitters (122), Aufbringen eines dielektrischen Kapselungsmaterials (132), das an den Enden (118) des Halbleiterabschnitts (104), der dritten Abschnitte (116) des Halbleiterabschnitts (104) und der inneren dielektrischen Abstandshalter (112) angeordnet ist;
- zwischen den Schritten des Entfernens des Dummy-Gitters (122) und dem Herstellen der elektrisch leitenden Abschnitte (120, 131), einen Schritt des Gravierens von Stellen (134) der elektrisch leitenden Abschnitte (120, 131) in dem dielektrischen Kapselungsmaterial (132), wobei die elektrisch leitenden Abschnitte (120, 131) anschließend in den gravierten Stellen (134) hergestellt werden.

12. Verfahren nach Anspruch 11, das ferner bei dem Herstellen der elektrisch leitenden Abschnitte (120, 131) das Durchführen eines Schrittes des Silizifizierens der dotierten Oberflächen der Enden (118) und der dritten Teile (116) des Halbleiterabschnitts (104) aufweist.

## Claims

1. FET transistor (100) comprising at least:
- a semiconductor portion (104) of which a first part (106) forms a channel of the FET transistor (100);
- a gate (108) which at least partly surrounds the first part (106) of the semiconductor portion (104);
- internal dielectric spacers (112) arranged around second doped parts (114) of the semiconductor portion (104) between which the first part (106) of the semiconductor portion (104) is arranged and which form extension regions of the FET transistor (100);
- electrically conductive portions (120) in contact with doped surfaces of extremities (118) of the semiconductor portion (104) and with doped surfaces of third parts (116) of the semiconductor portion (104), forming part of the source and drain regions of the FET transistor (100), at least partly surrounding the third parts (116) of the semiconductor portion (104), with each of the second parts (114) of the semiconductor portion (104) being arranged between the first part (106) of the semiconductor portion (104) and one of the third parts (116) of the semiconductor portion (104);
comprising moreover external dielectric spacers (110) between which the gate (108) is arranged and which partly surround an assembly formed by at least the second and third parts (114, 116) of the semiconductor portion (104), the internal dielectric spacers (112) and the parts of the electrically conductive portions (120) in contact with the doped surfaces of the third parts (116) of the semiconductor portion (104);
wherein the doped surfaces (118) of the extremities of the semiconductor portion (104) correspond to surfaces of that semiconductor portion which are substantially perpendicular to the direction of current flow in the channel of the FET transistor (100);
and wherein a portion of each of the external dielectric spacers (110) is disposed against one of the inner dielectric spacers (112) disposed between each of the external dielectric spacers (110) and one of the second doped parts (114) of the semiconductor portion (104).

2. FET transistor (100) according to claim 1, wherein:
- the semiconductor portion (104) is suspended above a substrate (102);
- a part of the gate (108) is arranged between the first part (106) of the semiconductor portion (104) and the substrate (102);
- a part of each of the internal dielectric spacers (112) is arranged between one of the second parts (114) of the semiconductor portion (104) and the substrate (102);
- a part of each of the electrically conductive portions (120) is arranged between one of the third parts (116) of the semiconductor portion (104) and the substrate (102).

3. FET transistor (100) according to claim 2, comprising several semiconductor portions (104) suspended above the substrate (102) and such that the first parts (106) of the semiconductor portions (104) together form the transistor channel (100) and wherein:
- the gate (108) surrounds each of the first parts (106) of the semiconductor portions (104);
- the internal dielectric spacers (112) are arranged around the second parts (114) of each of the semiconductor portions (104);
- the electrically conductive portions (120) are in contact with the doped surfaces of the extremities (118) of each of the semiconductor portions (104) and with the doped surfaces of the third parts (116) of each of the semiconductor portions (104).

4. FET transistor (100) according to one of the preceding claims, wherein the second parts (114) of the semiconductor portion (104) comprise doped surfaces.

5. FET transistor (100) according to one of the preceding claims, wherein the internal dielectric spacers (112) comprise a material of dielectric permittivity less than or equal to about 3.9.

6. FET transistor (100) according to one of the preceding claims, wherein the electrically conductive portions (120) comprise at least one metal.

7. FET transistor (100) according to one of the preceding claims, wherein a layer of silicide (131) is interposed between the doped surfaces of the extremities (118) and third parts (116) of the semiconductor portion (104) and the electrically conductive portions (120).

8. Method for making at least one FET transistor (100), comprising at least the implementation of the following steps:
- making of at least one semiconductor portion (104) a first part (106) of which is intended to form a FET transistor (100) channel and which moreover comprises second parts (114) between which is arranged the first part (106) of the semiconductor portion (104) and intended to form extension regions of the FET transistor (100), as well as third parts (116) intended to form part of the source and drain regions of the FET transistor (100) and such that each of the second parts (114) of the semiconductor portion (104) is arranged between the first part (106) of the semiconductor portion (104) and one of the third parts (116) of the semiconductor portion (104);
- making of a dummy gate (122) at least partly surrounding the first part (106) of the semiconductor portion (104);
- doping of at least the third parts (116) of the semiconductor portion (104) and of extremities (118) of the semiconductor portion (104);
- deposition of at least one dielectric material (128) around the second and third parts (114, 116) of the semiconductor portion (104);
- removal of portions of the dielectric material (128) arranged around the third parts (116) of the semiconductor portion (104), where remaining portions of the dielectric material (128) arranged around the second parts (114) of the semiconductor portion (104) form internal dielectric spacers (112);
- removal of the dummy gate (122) and making, in a location formed by the removal of the dummy gate (122) of a gate (108) at least partly surrounding the first part (106) of the semiconductor portion (104);
- making electrically conductive portions (120) in contact with doped surfaces of extremities (118) of the semiconductor portion (104) and with doped surfaces of the third parts (116) of the semiconductor portion (104), and at least partly surrounding the third parts (116) of the semiconductor portion (104).

9. Method according to claim 8, wherein the doping of the extremities (118) and of the third parts (116) of the semiconductor portion (104) is performed by implementing the following steps:
- deposition, at least against the surfaces formed by the extremities (118) and the third parts (116) of the semiconductor portion (104), of a dielectric material (126) comprising dopants;
- thermal annealing which diffuses the dopants from the dielectric material (126) comprising the dopants to within the semiconductor of the extremities (118) and of the third parts (116) of the semiconductor portion (104);
- removal of the dielectric material (126) comprising the dopants.

10. Method according to one of claims 8 and 9, wherein the doping step is implemented such that the second parts (114) of the semiconductor portion (104) are also doped.

11. Method according to one of claims 8 to 10, moreover comprising:
- between the steps for removal of the portions of the dielectric material (128) and removal of the dummy gate (122), deposition of a dielectric encapsulation material (132) arranged against the extremities (118) of the semiconductor portion (104), the third parts (116) of the semiconductor portion (104) and the internal dielectric spacers (112);
- between the steps for removal of the dummy gate (122) and making of electrically conductive portions (120), a step for etching of locations (134) of electrically conductive portions (120) in the dielectric encapsulation material (132), with the electrically conductive portions (120) then being made in the etched locations (134).

12. Method according to claim 11, moreover further comprising when creating electrically conductive portions (120, 131), the implementation of a step for silicidation of the doped surfaces of the extremities (118) and of the third parts (116) of the semiconductor portion (104).
